(19) **Europäisches Patentamt** / **European Patent Office** / **Office européen des brevets**

(11) **EP 4 664 553 A1**

(12) **EUROPEAN PATENT APPLICATION**
published in accordance with Art. 153(4) EPC

(43) Date of publication:
**17.12.2025 Bulletin 2025/51**

(21) Application number: **24886148.6**

(22) Date of filing: **25.10.2024**

(51) International Patent Classification (IPC):
**H01M 4/36** $^{(2006.01)}$    **H01M 4/587** $^{(2010.01)}$
**C01B 32/956** $^{(2017.01)}$    **H01M 4/134** $^{(2010.01)}$
**H01M 10/052** $^{(2010.01)}$    **H01M 4/02** $^{(2006.01)}$

(52) Cooperative Patent Classification (CPC):
**C01B 32/956; H01M 4/02; H01M 4/134; H01M 4/36;**
**H01M 4/587; H01M 10/052;** Y02E 60/10

(86) International application number:
**PCT/KR2024/016372**

(87) International publication number:
**WO 2025/095473 (08.05.2025 Gazette 2025/19)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **31.10.2023 KR 20230147407**

(71) Applicant: **LG Energy Solution, Ltd.**
**Seoul 07335 (KR)**

(72) Inventors:
• **PARK, Heeyeon**
  **Daejeon 34122 (KR)**
• **SHIN, Sun Young**
  **Daejeon 34122 (KR)**
• **HEO, Bumgi**
  **Daejeon 34122 (KR)**
• **LEE, Yong Ju**
  **Daejeon 34122 (KR)**

(74) Representative: **Hoffmann Eitle**
**Patent- und Rechtsanwälte PartmbB**
**Arabellastraße 30**
**81925 München (DE)**

(54) **NEGATIVE ELECTRODE ACTIVE MATERIAL, NEGATIVE ELECTRODE SLURRY, NEGATIVE ELECTRODE, AND SECONDARY BATTERY**

(57)    The present invention relates to a negative electrode active material, a negative electrode slurry, a negative electrode comprising same, and a secondary battery comprising the negative electrode, the negative electrode active material comprising a silicon-carbon composite, a carbon layer provided on at least a portion of the silicon-carbon composite, and a coating layer of a catechol derivative or a gallol derivative provided on at least a portion of at least one of the silicon-carbon composite and the carbon layer.

EP 4 664 553 A1

**Description**

[Technical Field]

The present invention relates to a negative electrode active material, a negative electrode slurry, a negative electrode including the negative electrode slurry, and a secondary battery including the negative electrode.
This application claims priority to and the benefit of Korean Patent Application No. 10-2023-0147407 filed in the Korean Intellectual Property Office on October 31, 2023, the entire contents of which are incorporated herein by reference.

[Background Art]

Demands for the use of alternative energy or clean energy are increasing due to the rapid increase in the use of fossil fuels, and as a part of this trend, the most actively studied field is a field of electricity generation and electricity storage using an electrochemical reaction.
Currently, representative examples of an electrochemical device using such electrochemical energy include a secondary battery, and the usage areas thereof are increasing more and more. Recently, the demand for secondary batteries as an energy source has been rapidly increasing as the technical development and the demand for portable devices such as portable computers, portable telephones, and cameras increase. Among such secondary batteries, lithium secondary batteries having a high energy density, that is, high capacity have been extensively studied, commercialized and widely used.
In general, a secondary battery is composed of a positive electrode, a negative electrode, an electrolyte, and a separator. The negative electrode includes a negative electrode active material capable of intercalation and deintercalation of lithium ions from the positive electrode, graphite is usually used as a negative electrode active material of a lithium secondary battery, but it is difficult to increase the capacity of a lithium secondary battery because graphite has a small capacity per unit mass of 372 mAh/g. Accordingly, in order to increase the capacity of a lithium secondary battery, negative electrode materials such as silicon, tin and oxides thereof have been developed as non-carbon-based negative electrode materials having higher energy density than graphite. However, although these non-carbon-based negative electrode materials have a large capacity, these materials have a problem in that the amount of lithium consumed is large and the irreversible capacity loss is large during the initial charging and discharging due to the low initial efficiency.

[Related Art Document]

(Patent Document 1) Korean Patent Application Publication No. 10-2019-0129017

[Detailed Description of the Invention]

[Technical Problem]

The present invention has been made in an effort to provide a negative electrode active material capable of improving initial efficiency or service life characteristics when applied to a secondary battery, reducing the viscosity of a slurry, and ameliorating the problem of gas generation, a negative electrode slurry, and a negative electrode and a secondary battery including the same.

[Technical Solution]

An exemplary embodiment of the present invention provides a negative electrode active material including a silicon carbon composite; a carbon layer provided on at least a portion of the silicon carbon composite; and a coating layer of a catechol derivative or gallol derivative provided on at least a portion of at least one of the silicon carbon composite and the carbon layer.
An exemplary embodiment of the present invention provides a method for preparing a negative electrode active material, the method including: forming a carbon layer on at least a portion of a silicon carbon composite; and forming a coating layer of a catechol derivative or gallol derivative on at least a portion of at least one of the silicon carbon composite and the carbon layer.
An exemplary embodiment of the present invention provides a negative electrode slurry including a negative electrode active material including a silicon carbon composite and a coating layer of a catechol derivative or gallol derivative provided on at least a portion of the silicon carbon composite; and a catechol derivative or gallol derivative additive.
An exemplary embodiment of the present invention provides a negative electrode including a negative electrode current collector; and a negative electrode active material layer including the negative electrode slurry or a cured or polymerized product thereof provided on at least one surface of the negative electrode current collector.

An exemplary embodiment of the present invention provides a secondary battery including the negative electrode; a separator; and a positive electrode. An exemplary embodiment of the present invention provides a battery module including the secondary battery, and a battery pack including the same.

An exemplary embodiment of the present invention provides a battery pack including the secondary battery.

[Advantageous Effects]

The negative electrode active material according to exemplary embodiments of the present invention can prevent the problem of gas generation caused by the contact of silicon with water in an aqueous process by using a silicon carbon composite as a core material of the negative electrode active material to achieve high capacity and high efficiency, and simultaneously including a carbon layer and a coating layer of a catechol derivative or gallol derivative.

Further, the negative electrode slurry according to exemplary embodiments of the present invention includes a negative electrode active material and a catechol derivative or gallol derivative additive, thereby is capable of controlling the volume expansion. Specifically, the adhesion between the negative electrode active material and the binder can be increased by using a coating layer of the catechol derivative or gallol derivative in the negative electrode active material together with the catechol derivative or gallol derivative additive to three-dimensionally bond the negative electrode active material with a binder, and accordingly, the volume expansion can be suppressed to improve service life characteristics.

[Best Mode]

Hereinafter, the present invention will be described in more detail in order to help the understanding of the present invention.

Terms or words used in the specification and the claims should not be interpreted as being limited to typical or dictionary meanings and should be interpreted with a meaning and a concept that are consistent with the technical spirit of the present invention based on the principle that an inventor can appropriately define the concept of a term in order to describe his/her own invention in the best way.

The terms used in the present specification are used only to describe exemplary embodiments, and are not intended to limit the present invention. Singular expressions include plural expressions unless the context clearly indicates otherwise.

In the present invention, the term "comprise", "include", or "have" is intended to indicate the presence of the characteristic, number, step, constituent element, or any combination thereof implemented, and should be understood to mean that the possibility of the presence or addition of one or more other characteristics or numbers, steps, constituent elements, or any combination thereof is not precluded.

In the present specification, a description of one member being placed "on" another member includes not only a case of the one member adjoining another member but a case of still another member being present between the two members.

In the present specification, the presence or absence of an element and the content of the element in a negative electrode active material can be confirmed by ICP analysis, and the ICP analysis may be performed using an inductively coupled plasma atomic emission spectrometer (ICPAES, Perkin Elmer 7300).

In the present specification, an average particle diameter ($D_{50}$) may be defined as a particle diameter corresponding to 50% of a cumulative volume in a particle diameter distribution curve of the particles. The average particle diameter ($D_{50}$) may be measured using, for example, a laser diffraction method. The laser diffraction method can generally measure a particle diameter of from the submicron region to about several mm, and results with high reproducibility and high resolution may be obtained.

The measurement of the average particle diameter ($D_{50}$) may be confirmed using water and Triton-X100 dispersant using a Microtrac apparatus (manufacturer: Microtrac model name: S3500). Specifically, the average particle diameter ($D_{50}$) of the positive electrode active material particles may be measured in a range of a refractive index of 1.5 to 1.7, and the negative electrode active material may be measured under the condition of a refractive index of 1.97 or 2.42. For example, after particles are dispersed in a dispersion medium, the resulting dispersion is introduced into a commercially available laser diffraction particle size measuring device to irradiate the dispersion with an ultrasonic wave of about 28 kHz with an output of 60 W, then a volume cumulative particle size distribution graph is obtained, and then the average particle diameter may be measured by obtaining the particle size corresponding to 50% of the volume cumulative amount.

In the present specification, the specific surface area of the negative electrode active material may be measured by a Brunauer-Emmett-Teller (BET) method. For example, the specific surface area of the negative electrode active material may be measured by a BET six-point method by a nitrogen gas adsorption distribution method using a porosimetry analyzer (Bell Japan Inc., Belsorp-±).

<Negative electrode active material>

A negative electrode active material according to an exemplary embodiment of the present invention is characterized by including a silicon carbon composite; a carbon layer provided on at least a portion of the silicon carbon composite; and a coating layer of a catechol derivative or gallol derivative provided on at least a portion of at least one of the silicon carbon composite and the carbon layer.

The negative electrode active material includes a silicon carbon composite as a core. Since the coating layer of the catechol derivative or gallol derivative is formed after the formation of the carbon layer, the coating layer may be provided on the carbon layer, or may also be provided on the surface of the silicon carbon composite not including the carbon layer. In addition, the coating layer of the catechol derivative or gallol derivative may completely cover the carbon layer, but may also be formed only on a portion of the carbon layer, so that both the carbon layer and the coating layer of the catechol derivative or gallol derivative may be observed on the surface of the negative electrode active material.

When both the carbon layer and the coating layer of the catechol derivative or gallol derivative are observed on the surface of the negative electrode active material, the coating layer of the catechol derivative or gallol derivative is located at the outermost shell, so that there is an effect capable of improving the service life performance because the functional group of the catechol derivative or gallol derivative and the functional group of the binder interact with each other through hydrogen bonding.

Even when silicon exposed on the surface of the silicon carbon composite is present, the negative electrode active material includes a carbon layer and a coating layer of a catechol derivative or gallol derivative, thereby is capable of blocking contact of the exposed silicon with the outside to improve aqueous processability through a passivation effect.

And, the coating layer of the catechol derivative or gallol derivative may preferably form a polymer film on the surface of the carbon layer provided on at least a portion of the silicon carbon composite, and the polymer film has low solubility in water and is thus highly effective in suppressing gas generation.

The silicon carbon composite is a composite of Si and C, in which Si and C (for example, graphite) are each present. For example, each peak of Si and C may be observed by an elemental analysis method such as XRD or NMR. In the present specification, the silicon carbon composite may be represented by Si/C. The silicon carbon composite may be composed of Si and C that are not bonded to each other, but may also include additional components, if necessary. For example, the silicon carbon composite may or may not include silicon carbide represented by SiC. When the silicon carbon composite includes silicon carbide, the content thereof is 3 wt% or less. The silicon carbon composite may be present in a state of crystalline, amorphous, or a mixture thereof. According to an example, C in the silicon carbon composite may be present in an amorphous state.

The silicon carbon composite may be a Si/C-based active material.

The silicon carbon composite may be a composite of silicon, graphite, and the like, and may also form a structure in which a core resulting from compositing of silicon and graphite and the like is surrounded by graphene, amorphous carbon or the like. In the silicon carbon composite, the silicon may be silicon nanoparticles.

The silicon carbon composite includes porous carbon-based particles and silicon particles located on the surface or in the internal pores of the porous carbon-based particles.

As an example, the silicon carbon composite may be prepared by a method including: etching carbon-based particles including internal pores to expand the internal pores of the carbon-based particles; and forming silicon particles on the surface or in the internal pores of the carbon-based particles including expanded internal pores.

The expanding of the internal pores of the carbon-based particles may be performed in a nitrogen ($N_2$) atmosphere, an oxygen ($O_2$) atmosphere, or an air atmosphere including oxygen. Specifically, the flow rate of the oxygen ($O_2$) or the air including oxygen may be controlled at 0.1 to 10 L/min.

The expanding of the internal pores of the carbon-based particles may be performed at a temperature range of 400°C to 1200°C for 30 minutes to 4 hours.

Depending on the conditions for expanding the internal pores of the carbon-based particles, the pore characteristics of the resulting porous carbon-based particles may vary.

The forming of the silicon particles may be performed using a chemical vapor deposition method. In this case, silicon nanoparticles may be deposited on the surface and/or internal pores of the carbon-based particles with expanded internal pores, thereby forming a silicon coating layer in the form of a film, an island, or a mixture thereof.

According to an exemplary embodiment of the present invention, the catechol derivative includes one or more selected from dopamine, norepinephrine, and catechin, or a salt thereof or a polymer thereof, and the gallol derivative includes one or more selected from tannic acid, gallocatechin, and gallocatechin gallate, or a salt thereof or a polymer thereof.

The catechol derivative may be present in the form of a hydrochloride salt, and may be present in the form of, for example, dopamine hydrochloride or norepinephrine hydrochloride.

According to an exemplary embodiment of the present invention, the content of the coating layer of the catechol derivative or gallol derivative is 0.5 parts by weight or more and less than 5 parts by weight based on total 100 parts by weight of the negative electrode active material. Specifically, the content of the coating layer of the catechol derivative or gallol derivative may be 0.5 parts by weight or more, 0.6 parts by weight or more, 0.7 parts by weight or more, 0.8 parts by weight or more, 0.9 parts by weight or more, or 1 part by weight or more, and less than 5 parts by weight, less than 4.9 parts by weight, less than 4.8 parts by weight, less than 4.7 parts by weight, less than 4.6 parts by weight, or less than 4.5 parts by weight, based on total 100 parts by weight of the negative electrode active material.

When the coating layer of the catechol derivative or gallol derivative satisfies the above range, the silicon carbon composite having a higher capacity than a SiOx-based active material is included in a suitable amount, so that the capacity balance with the positive electrode active material may be achieved, and the problem of gas generation caused by the contact of silicon with water in the aqueous process may be prevented.

According to an exemplary embodiment of the present invention, the content of the carbon layer is 0.1 to 50 parts by weight based on total 100 parts by weight of the negative electrode active material. Specifically, the carbon layer may be included in an amount of 0.1 parts by weight to 30 parts by weight, 0.1 parts by weight to 20 parts by weight, 0.5 parts by weight to 15 parts by weight, or 1 part by weight to 10 parts by weight based on total 100 parts by weight of the negative electrode active material.

When the above range is satisfied, the conductivity of the negative electrode active material is improved, and the volume change of the negative electrode active material during the charging and discharging of a battery is readily suppressed, so that the service life characteristics of the battery may be improved.

The carbon layer may be formed by a chemical vapor deposition (CVD) method using at least one hydrocarbon gas selected from the group consisting of methane, ethane and acetylene.

The carbon layer may include at least any one of amorphous carbon and crystalline carbon.

The crystalline carbon may further improve the conductivity of the negative electrode active material.

The crystalline carbon may include at least any one selected from the group consisting of fullerene, carbon nanotube and graphene.

The amorphous carbon may suppress the expansion of the negative electrode active material by appropriately maintaining the strength of the carbon layer. The amorphous carbon may be a carbide of at least any one substance selected from the group consisting of tar, pitch and other organic materials, or may be a carbon-based material formed using a hydrocarbon as a source of a chemical vapor deposition method.

The carbide of the other organic materials may be a carbide of sucrose, glucose, galactose, fructose, lactose, mannose, ribose, aldohexose or ketohexose and a carbide of an organic material selected from combinations thereof.

The hydrocarbon may be a substituted or unsubstituted aliphatic or alicyclic hydrocarbon, or a substituted or unsubstituted aromatic hydrocarbon. The aliphatic or alicyclic hydrocarbon may be methane, ethane, ethylene, acetylene, propane, butane, butene, pentane, isobutane, hexane, or the like. Examples of the aromatic hydrocarbon of the substituted or unsubstituted aromatic hydrocarbon include benzene, toluene, xylene, styrene, ethylbenzene, diphenylmethane, naphthalene, phenol, cresol, nitrobenzene, chlorobenzene, indene, coumarone, pyridine, anthracene, phenanthrene, or the like.

According to an exemplary embodiment of the present invention, the negative electrode active material has an average particle diameter ($D_{50}$) of 0.1 $\mu$m to 30 $\mu$m. Specifically, the negative electrode active material may have an average particle diameter ($D_{50}$) of 1 $\mu$m to 20 $\mu$m or 1 $\mu$m to 10 $\mu$m, and 2 $\mu$m to 10 $\mu$m. When the average particle diameter ($D_{50}$) of the negative electrode active material satisfies the above range, the dispersibility of the active material during preparation of the negative electrode slurry is appropriate, the structural stability of the active material during charging and discharging is achieved, and there are few problems with coating defects caused by large particles during electrode coating. Furthermore, it is possible to prevent the problem of the volume expansion/contraction level from becoming large as the particle diameter becomes excessively large, and to prevent the problem of the initial efficiency from decreasing as the particle diameter becomes excessively small.

According to an exemplary embodiment of the present invention, the negative electrode active material has a BET specific surface area of preferably 20 m$^2$/g or less, for example, 10 m$^2$/g or less. For example, the negative electrode active material may have a BET specific surface area of 0.1 m$^2$/g to 10 m$^2$/g, for example, 1 m$^2$/g to 8 m$^2$/g, or 4 m$^2$/g to 6 m$^2$/g. The specific surface area may be measured by a Brunauer-Emmett-Teller (BET) method. For example, the specific surface area of the negative electrode active material may be measured by a BET six-point method by a nitrogen gas adsorption distribution method using a porosimetry analyzer (Bell Japan Inc., Belsorp-II mini).

<u>**Method for preparing negative electrode active material**</u>

A method for preparing a negative electrode active material according to an exemplary embodiment of the present invention may include: forming a carbon layer on at least a portion of a silicon carbon composite; and forming a coating layer of a catechol derivative or gallol derivative on at least a portion of at least one of the silicon carbon composite and the carbon layer.

Before or after the carbon layer is formed, the particle diameter of the negative electrode active material may be adjusted by a pulverization method such as a mechanical milling method, if necessary.

The forming of the carbon layer on the surface of the negative electrode active material may be performed by a method of injecting a carbon-based raw material gas such as methane gas and performing a heat treatment in a rotary tubular furnace as an example. Specifically, a carbon layer may be formed by introducing the silicon-based oxide particles into a rotary tubular furnace, increasing the temperature to 800°C to 1,150°C, or 900°C to 1,050°C, or 950°C to 1,000°C at a rate of 3 to 10°C/min or about 5°C/min, flowing an argon gas and a carbon-based material raw material gas while rotating the rotary tubular furnace, and performing a heat treatment for 30 minutes to 8 hours.

The forming of the coating layer of the catechol derivative or gallol derivative is performed on a portion of at least one of the silicon carbon composite and the carbon layer formed as described above. For the coating layer of the catechol derivative or gallol derivative, it is possible to use an oxidative self-polymerization method in which a polymer is formed by adding a catechol derivative or gallol derivative to a weakly basic solution. As the weakly basic solution, a solution such as a tris-HCl buffer or a bicine buffer may be used, and the pH of the weakly basic solution may be 7.5 or more and 9 or less. Specifically, the pH lower limit of the weakly basic solution may be 7.5, 7.6, 7.7, 7.8, 7.9, or 8.0, and the pH upper limit of the weakly basic solution may be 9.0, 8.9, 8.8, 8.7, 8.6, or 8.5.

In order for the oxidative self-polymerization reaction to occur properly, the content of a solid including the catechol or gallol derivative, the silicon carbon composite, and the like is preferably 0.1 to 5%.

**<Negative electrode slurry>**

A negative electrode slurry according to an exemplary embodiment of the present invention includes a negative electrode active material including a silicon carbon composite and a coating layer of a catechol derivative or gallol derivative provided on at least a portion of the silicon carbon composite; and a catechol derivative or gallol derivative additive.

The negative electrode slurry according to an exemplary embodiment of the present invention includes a negative electrode active material including a silicon carbon composite, a carbon layer provided on at least a portion of the silicon carbon composite, and a coating layer of a catechol derivative or gallol derivative provided on at least a portion of at least one of the silicon carbon composite and the carbon layer; and a catechol derivative or gallol derivative additive.

The catechol derivative or gallol derivative included in the coating layer provided on at least a portion of the silicon carbon composite may be the same as or different from the catechol derivative or gallol derivative of the additive.

The catechol derivative or gallol derivative is used as an additive and a coating layer provided on at least a portion of the silicon carbon composite, and thus, has an effect of improving the stability of the slurry, such as preventing a decrease in viscosity, due to an interaction between the coating layer and the additive.

According to an exemplary embodiment of the present invention, in the negative electrode active material included in the negative electrode slurry, the content of the coating layer of the catechol derivative or gallol derivative is 0.5 parts by weight or more and less than 5 parts by weight based on total 100 parts by weight of the negative electrode active material. Specifically, the coating layer of the catechol derivative or gallol derivative may be 0.5 parts by weight or more, 0.6 parts by weight or more, 0.7 parts by weight or more, 0.8 parts by weight or more, 0.9 parts by weight or more, or 1.0 part by weight or more, and less than 5 parts by weight, less than 4.9 parts by weight, less than 4.8 parts by weight, less than 4.7 parts by weight, less than 4.6 parts by weight, or less than 4.5 parts by weight, based on total 100 parts by weight of the negative electrode active material.

When the coating layer of the catechol derivative or gallol derivative satisfies the above range, the silicon carbon composite having a higher capacity than a SiOx-based active material is included in a suitable amount, so that the capacity balance with the positive electrode active material may be achieved, and the problem of gas generation caused by the contact of silicon with water in the aqueous process may be prevented.

According to an exemplary embodiment of the present invention, the content of the catechol derivative or gallol derivative additive in the negative electrode slurry is 0.01 to 0.5 parts by weight based on total 100 parts by weight of the solid content of the negative electrode slurry. Specifically, the content of the catechol derivative or gallol derivative additive in the negative electrode slurry may be 0.02 parts by weight or more, 0.03 parts by weight or more, 0.04 parts by weight or more, or 0.05 parts by weight or more, and 0.49 parts by weight or less, 0.48 parts by weight or less, 0.47 parts by weight or less, 0.46 parts by weight or less, or 0.45 parts by weight or less, based on total 100 parts by weight of the solid content of the negative electrode slurry.

When the content of the catechol derivative or gallol derivative additive satisfies the above range, the volume expansion may be controlled by three-dimensional bonding with a binder, and the catechol derivative or gallol derivative itself is an insulator, but it may be transformed into a material capable of conducting electricity during the initial charge and discharge process and may also play serve as a conductive material.

According to an exemplary embodiment of the present invention, the negative electrode active material included in the negative electrode slurry includes the above-described carbon layer between the silicon carbon composite and a coating layer of a catechol derivative or a gallol derivative provided on at least a portion of the silicon carbon composite.

According to an exemplary embodiment of the present invention, the content of the carbon layer is 0.1 to 50 parts by weight based on total 100 parts by weight of the negative electrode active material. Specifically, the carbon layer may be included in an amount of 0.1 parts by weight to 30 parts by weight, 0.1 parts by weight to 20 parts by weight, 0.5 parts by weight to 15 parts by weight, or 1 part by weight to 10 parts by weight based on total 100 parts by weight of the negative electrode active material.

The negative electrode slurry may further include an additional negative electrode active material.

As the additional negative electrode active material, a compound capable of reversible intercalation and deintercalation of lithium may be used. Specific examples thereof include a carbonaceous material such as artificial graphite, natural graphite, graphized carbon fiber, and amorphous carbon; a metallic compound alloyable with lithium such as Si, Al, Sn, Pb, Zn, Bi, In, Mg, Ga, Cd, a Si alloy, a Sn alloy, or an Al alloy; a metal oxide which may be undoped and doped with lithium such as $SiO_\beta$ ($0 < \beta < 2$), $SnO_2$, vanadium oxide, lithium titanium oxide, and lithium vanadium oxide; or a composite including the metallic compound and the carbonaceous material such as a Si-C composite or a Sn-C composite, and the like, and any one thereof or a mixture of two or more thereof may be used. Furthermore, a metallic lithium thin film may be used as the negative electrode active material. And, both low crystalline carbon and high crystalline carbon, and the like may be used as the carbon material. Typical examples of the low crystalline carbon include soft carbon and hard carbon, and typical examples of the high crystalline carbon include irregular, planar, flaky, spherical, or fibrous natural graphite or artificial graphite, Kish graphite, pyrolytic carbon, mesophase pitch-based carbon fibers, meso-carbon microbeads, mesophase pitches, and high-temperature fired carbon such as petroleum or coal tar pitch derived cokes.

The additional negative electrode active material may be a carbon-based negative electrode active material.

A weight ratio of the negative electrode active material and the additional negative electrode active material included in the negative electrode slurry may be 10:90 to 90:10, specifically 10:90 to 50:50.

The negative electrode slurry may include a solvent for forming a negative electrode slurry. Specifically, the solvent for forming a negative electrode slurry may include at least one selected from the group consisting of distilled water, ethanol, methanol, and isopropyl alcohol, specifically distilled water in terms of facilitating the dispersion of the components.

The negative electrode slurry according to an exemplary embodiment of the present invention further includes a binder; and a conductive material.

The binder may serve to improve the bonding between negative electrode active materials and the adhesion between the negative electrode active materials and the negative electrode current collector. As the binder, those known in the art may be used, and non-limiting examples thereof may include at least any one selected from the group consisting of a polyvinylidene fluoride-hexafluoropropylene copolymer (PVDF-co-HFP), polyvinylidene fluoride, polyacrylonitrile, polymethylmethacrylate, polyvinyl alcohol, carboxymethyl cellulose (CMC), starch, hydroxypropyl cellulose, regenerated cellulose, polyvinylpyrrolidone, polytetrafluoroethylene, polyethylene, polypropylene, an ethylene-propylene-diene monomer (EPDM), a sulfonated EPDM, styrene butadiene rubber (SBR), fluorine rubber, polyacrylic acid and a material in which the hydrogen thereof is substituted with Li, Na, Ca, or the like, and may also include various copolymers thereof.

The binder may be included in an amount of 0.1 parts by weight or more and 50 parts by weight or less, for example, preferably 0.3 parts by weight or more and 35 parts by weight or less, and more preferably 0.5 parts by weight or more and 10 parts by weight or less, based on 100 parts by weight of the negative electrode active material layer.

The conductive material is not particularly limited as long as the conductive material has conductivity without causing a chemical change to the battery, and for example, it is possible to use graphite such as natural graphite or artificial graphite; carbon black such as acetylene black, Ketjen black, channel black, furnace black, lamp black, and thermal black; a conductive fiber such as carbon fiber or metal fiber; a conductive tube such as a carbon nanotube; a metal powder such as a fluorocarbon powder, an aluminum powder, and a nickel powder; a conductive whisker such as zinc oxide and potassium titanate; a conductive metal oxide such as titanium oxide; a conductive material such as polyphenylene derivatives, and the like.

## <Negative electrode>

A negative electrode according to an exemplary embodiment of the present invention may include a negative electrode current collector; and a negative electrode active material layer including the negative electrode slurry or a cured or polymerized product thereof provided on at least one surface of the negative electrode current collector. The negative electrode active material layer may include the negative electrode active material, and the negative electrode active material may include the above-described negative electrode active material. Furthermore, the negative electrode active material layer may further include a binder and/or a conductive material.

The negative electrode current collector is sufficient as long as the negative electrode current collector has conductivity without causing a chemical change to the battery, and is not particularly limited. For example, as the current collector, it is possible to use copper, stainless steel, aluminum, nickel, titanium, fired carbon, or aluminum or stainless steel whose surface is treated with carbon, nickel, titanium, silver, and the like. Specifically, a transition metal, such as copper or nickel which adsorbs carbon well, may be used as a current collector. Although the current collector may have a thickness of 1 μm to 500 μm, the thickness of the current collector is not limited thereto.

**<Secondary battery>**

A secondary battery according to an exemplary embodiment of the present invention may include the above-described negative electrode. Specifically, the secondary battery may include a negative electrode, a positive electrode, a separator interposed between the positive electrode and the negative electrode, and an electrolyte.

The positive electrode may include a positive electrode current collector and a positive electrode active material layer disposed on the positive electrode current collector, and may include a positive electrode active material layer including a positive electrode active material. The positive electrode active material layer may include the positive electrode active material.

The positive electrode current collector is not particularly limited as long as the collector has conductivity without causing a chemical change to a battery, and for example, it is possible to use stainless steel, aluminum, nickel, titanium, calcined carbon, or aluminum or stainless steel whose surface is treated with carbon, nickel, titanium, silver, and the like. And, the positive electrode current collector may typically have a thickness of 3 to 500 μm, and the adhesion of the positive electrode active material may also be enhanced by forming fine irregularities on the surface of the current collector. For example, the positive electrode current collector may be used in various forms such as a film, a sheet, a foil, a net, a porous body, a foam body, and a non-woven fabric body.

The positive electrode active material may be a typically used positive electrode active material. Specifically, the positive electrode active material includes: a layered compound such as lithium cobalt oxide ($LiCoO_2$) and lithium nickel oxide ($LiNiO_2$) or a compound substituted with one or more transition metals; a lithium iron oxide such as $LiFe_3O_4$; a lithium manganese oxide such as chemical formula $Li_{1+c1}Mn_{2-c1}O_4$ ($0 \leq c1 \leq 0.33$), $LiMnO_3$, $LiMn_2O_3$, and $LiMnO_2$; a lithium copper oxide ($Li_2CuO_2$); a vanadium oxide such as $LiV_3O_8$, $V_2O_5$, and $Cu_2V_2O_7$; a Ni site type lithium nickel oxide expressed as chemical formula $LiNi_{1-c2}M_{c2}O_2$ (here, M is at least any one selected from the group consisting of Co, Mn, Al, Cu, Fe, Mg, B and Ga, and c2 satisfies $0.01 \leq c2 \leq 0.3$); a lithium manganese composite oxide expressed as chemical formula $LiMn_{2-c3}M_{c3}O_2$ (here, M is at least any one selected from the group consisting of Co, Ni, Fe, Cr, Zn and Ta, and c3 satisfies $0.01 \leq c3 \leq 0.1$) or $Li_2Mn_3MO_8$ (here, M is at least any one selected from the group consisting of Fe, Co, Ni, Cu and Zn.); $LiMn_2O_4$ in which Li of the chemical formula is partially substituted with an alkaline earth metal ion, and the like, but is not limited thereto. The positive electrode may be Li-metal.

The positive electrode active material layer may include a positive electrode conductive material and a positive electrode binder together with the above-described positive electrode active material.

In this case, the positive electrode conductive material is used to impart conductivity to the electrode, and can be used without particular limitation as long as the positive electrode conductive material has electron conductivity without causing a chemical change to a battery to be constituted. Specific examples thereof include graphite such as natural graphite or artificial graphite; a carbon-based material such as carbon black, acetylene black, Ketjen black, channel black, furnace black, lamp black, thermal black, and carbon fiber; metal powder or metal fiber such as copper, nickel, aluminum, and silver; a conductive whisker such as zinc oxide and potassium titanate; a conductive metal oxide such as titanium oxide; or a conductive polymer such as a polyphenylene derivative, and any one thereof or a mixture of two or more thereof may be used.

And, the positive electrode binder serves to improve the bonding between positive electrode active material particles and the adhesion between the positive electrode active material and the positive electrode current collector. Specific examples thereof may include polyvinylidene fluoride (PVDF), a polyvinylidene fluoride-hexafluoropropylene copolymer (PVDF-co-HFP), polyvinyl alcohol, polyacrylonitrile, carboxymethyl cellulose (CMC), starch, hydroxypropyl cellulose, regenerated cellulose, polyvinylpyrrolidone, polytetrafluoroethylene, polyethylene, polypropylene, an ethylene-propylene-diene monomer (EPDM), a sulfonated EPDM, styrene-butadiene rubber (SBR), fluorine rubber, or various copolymers thereof, and any one thereof or a mixture of two or more thereof may be used.

The positive electrode and the negative electrode may be manufactured by a method for manufacturing a positive electrode and a negative electrode in the related art, except that the aforementioned positive electrode and negative electrode active materials are used. Specifically, after a composition for forming an active material layer, which includes the active material and, optionally, a binder and a conductive material is applied onto current collectors, the positive electrode and negative electrode may be manufactured by drying and rolling the current collectors. In this case, the types and contents of the positive and negative electrode active materials, binders, and conductive materials are as described above. The solvent may be a solvent commonly used in the art, examples thereof include dimethyl sulfoxide (DMSO), isopropyl alcohol, N-methylpyrrolidone (NMP), acetone, water, or the like, and among them, any one thereof or a mixture of two or more thereof may be used. The amount of solvent used is sufficient as long as the solvent in the amount dissolves or disperses the active material, conductive material and binder in consideration of the application thickness and preparation yield of the slurry, and has a viscosity capable of exhibiting excellent thickness uniformity during subsequent application for manufacturing the positive electrode and the negative electrode. Further, by another method, the positive electrode and the negative electrode may be manufactured by casting the composition for forming an active material layer on a separate support and then laminating a film obtained by performing peel-off from the support on a current collector.

The separator separates the negative electrode and the positive electrode and provides a passage for movement of lithium ions, and can be used without particular limitation as long as the separator is typically used as a separator in a secondary battery, and in particular, a separator having an excellent ability to retain moisture of an electrolytic solution as well as low resistance to ion movement in the electrolyte is preferable. Specifically, it is possible to use a porous polymer film, for example, a porous polymer film formed of a polyolefin-based polymer such as an ethylene homopolymer, a propylene homopolymer, an ethylene/butene copolymer, an ethylene/hexene copolymer, and an ethylene/methacrylate copolymer, or a laminated structure of two or more layers thereof. In addition, a typical porous non-woven fabric, for example, a non-woven fabric made of a glass fiber having a high melting point, a polyethylene terephthalate fiber, and the like may also be used. Furthermore, a coated separator including a ceramic component or a polymeric material may be used to secure heat resistance or mechanical strength and may be selectively used as a single-layered or multi-layered structure.

Examples of the electrolyte include an organic liquid electrolyte, an inorganic liquid electrolyte, a solid polymer electrolyte, a gel-type polymer electrolyte, a solid inorganic electrolyte, a molten-type inorganic electrolyte, and the like, which can be used in the preparation of a lithium secondary battery, but are not limited thereto.

Specifically, the electrolyte may include a non-aqueous organic solvent and a metal salt.

As the non-aqueous organic solvent, it is possible to use, for example, an aprotic organic solvent, such as N-methyl-2-pyrrolidinone, propylene carbonate, ethylene carbonate, butylene carbonate, dimethyl carbonate, diethyl carbonate, $\gamma$-butyrolactone, 1,2-dimethoxy ethane, tetrahydrofuran, 2-methyl tetrahydrofuran, dimethyl sulfoxide, 1,3-dioxolane, formamide, dimethylformamide, dioxolane, acetonitrile, nitromethane, methyl formate, methyl acetate, phosphate triester, trimethoxy methane, a dioxolane derivative, sulfolane, methyl sulfolane, 1,3-dimethyl-2-imidazolidinone, a propylene carbonate derivative, a tetrahydrofuran derivative, ether, methyl propionate, and ethyl propionate.

In particular, among the carbonate-based organic solvents, cyclic carbonates ethylene carbonate and propylene carbonate may be preferably used because the cyclic carbonates have high permittivity as organic solvents of a high viscosity and thus dissociate a lithium salt well, and when the cyclic carbonate is mixed with a linear carbonate of a low viscosity and low permittivity such as dimethyl carbonate and diethyl carbonate in an appropriate ratio, it is able to prepare an electrolyte having a high electric conductivity, therefore such a combined use is more preferable.

As the metal salt, a lithium salt may be used, the lithium salt is a material which is easily dissolved in the non-aqueous electrolytic solution, and for example, as an anion of the lithium salt, it is possible to use one or more selected from the group consisting of $F^-$, $Cl^-$, $I^-$, $NO_3^-$, $N(CN)_2^-$, $BF_4^-$, $ClO_4^-$, $PF_6^-$, $(CF_3)_2PF_4^-$, $(CF_3)_3PF_3^-$, $(CF_3)_4PF_2^-$, $(CF_3)_5PF^-$, $(CF_3)_6P^-$, $CF_3SO_3^-$, $CF_3CF_2SO_3^-$, $(CF_3SO_2)_2N^-$, $(FSO_2)_2N^-$, $CF_3CF_2(CF_3)_2CO^-$, $(CF_3SO_2)_2CH^-$, $(SF_5)_3C^-$, $(CF_3SO_2)_3C^-$, $CF_3(CF_2)_7SO_3^-$, $CF_3CO_2^-$, $CH_3CO_2^-$, $SCN^-$ and $(CF_3CF_2SO_2)_2N^-$.

In the electrolyte, for the purpose of improving the service life characteristics of a battery, suppressing the decrease in battery capacity, and improving the discharge capacity of the battery, one or more additives, such as, for example, a halo-alkylene carbonate-based compound such as difluoroethylene carbonate, pyridine, triethylphosphite, triethanolamine, cyclic ether, ethylenediamine, n-glyme, hexamethyl phosphoric triamide, a nitrobenzene derivative, sulfur, a quinone imine dye, N-substituted oxazolidinone, N,N-substituted imidazolidine, ethylene glycol dialkyl ether, an ammonium salt, pyrrole, 2-methoxy ethanol, or aluminum trichloride may be further included in addition to the above electrolyte constituent components.

According to an exemplary embodiment of the present invention, provided are a battery module including the secondary battery as a unit cell, and a battery pack including the same. In addition, provided is a battery pack including the secondary battery. The battery module and battery pack include the secondary battery having high capacity, high rate characteristics, and high cycle characteristics. The secondary battery may be used as a power source for a medium- or large-sized device selected from the group consisting of an electric vehicle, a hybrid electric vehicle, a plug-in hybrid electric vehicle, and a power storage system.

Hereinafter, preferred embodiments will be suggested to facilitate understanding of the present invention, but the embodiments are only provided to illustrate the present invention, and it is apparent to those skilled in the art that various alterations and modifications are possible within the scope and technical spirit of the present invention, and it is natural that such alterations and modifications also fall within the accompanying claims.

<Preparation of negative electrode active material>

Example 1-1: Preparation of negative electrode active material

A 0.5 M aqueous sucrose solution was put into an autoclave and reacted at 180°C for 24 hours to synthesize spherical particles. Carbon-based particles obtained after the reaction were washed two to three times with ethanol. The carbon-based particles dried at 100°C for 12 hours or more were mixed with KOH at 1 : 3 parts by weight, and the mixture was heated at 800°C in a nitrogen atmosphere for 2 hours to expand pores. Thereafter, after washing with distilled water, the carbon-based particles were dried at 100°C for 12 hours or more, and then placed in the hot zone of a CVD device, and a gas with $SiH_4/H_2$ = 5/95 was flowed at a flow rate of 50 ml/min at 600°C for 2 hours to prepare a silicon/carbon composite. The silicon/carbon composite was placed in the hot zone of a CVD device, and methane was blown into the hot zone at 700°C using Ar as a carrier gas to react for 1 hour, thereby forming a carbon layer on the surface. Thereafter, tannic acid and the silicon/carbon composite were reacted at a weight ratio of 5:95 in a weakly basic aqueous solution at room temperature for 2 hours while stirring to prepare a negative electrode active material including a carbon layer and a tannic acid coating layer on the surface of the silicon/carbon composite.

Example 1-2: Preparation of negative electrode active material

A negative electrode active material was prepared in the same manner as in Example 1-1, except that the ratio of tannic acid to the silicon/carbon composite was a weight ratio of 10:90 during the preparation of the negative electrode active material.

Example 1-3: Preparation of negative electrode active material

A negative electrode active material was prepared in the same manner as in Example 1-1, except that the carbon layer was formed at 700°C for 2 hours during the preparation of the negative electrode active material.

Example 1-4: Preparation of negative electrode active material

A negative electrode active material was prepared in the same manner as in Example 1-1, except that tannic acid was replaced with dopamine hydrochloride during the preparation of the negative electrode active material.

Comparative Example 1-1: Preparation of negative electrode active material

A negative electrode active material was prepared in the same manner as in Example 1-1, except that a coating layer of a catechol derivative or gallol derivative was not formed during the preparation of the negative electrode active material.

Comparative Example 1-2: Preparation of negative electrode active material

A negative electrode active material was prepared in the same manner as in Example 1-1, except that the ratio of tannic acid to the silicon/carbon composite was a weight ratio of 30:70 during the preparation of the negative electrode active material.

Comparative Example 1-3: Preparation of negative electrode active material

A negative electrode active material was prepared in the same manner as in Example 1-1, except that a carbon layer was formed on the coating layer of the catechol derivative or gallol derivative during the preparation of the negative electrode active material.

[Table 1]

|  | Silicon carbon composite Content (wt.%) | Content (wt.%) of catechol derivative or gallol derivative coating layer | Content (wt.%) of carbon layer |
|---|---|---|---|
| Example 1-1 | 94.5 | 1.7 | 3.8 |
| Example 1-2 | 92.3 | 4.2 | 3.5 |
| Example 1-3 | 92.7 | 1.6 | 5.7 |
| Example 1-4 | 94.6 | 1.8 | 3.6 |

(continued)

|  | Silicon carbon composite Content (wt.%) | Content (wt.%) of catechol derivative or gallol derivative coating layer | Content (wt.%) of carbon layer |
|---|---|---|---|
| Comparative Example 1-1 | 95.9 | 0 | 4.1 |
| Comparative Example 1-2 | 81.3 | 15.7 | 3.0 |
| Comparative Example 1-3 | 95.3 | 0.7 | 4.0 |

<Preparation of negative electrode slurry>

Example 2-1: Preparation of negative electrode slurry

A mixed negative electrode active material in which the negative electrode active material prepared in Example 1-1 and artificial graphite were mixed at a weight ratio of 2:8, carbon black as a conductive material, carboxymethyl cellulose (CMC) and styrene butadiene rubber (SBR) as binders, and an additive (tannic acid) were mixed with water as a solvent at a weight ratio of the mixed negative electrode active material : the conductive material : the binder (CMC) : the binder (SBR) : the additive (tannic acid) = 96.4:1:1:1.5:0.1, thereby preparing a negative electrode slurry in Example 2-1.

Example 2-2: Preparation of negative electrode slurry

A negative electrode slurry of Example 2-2 was prepared in the same manner as in Example 2-1, except that the negative electrode active material of Example 1-2 was used during the preparation of the negative electrode slurry.

Example 2-3: Preparation of negative electrode slurry

A negative electrode slurry of Example 2-3 was prepared in the same manner as in Example 2-1, except that the negative electrode active material of Example 1-3 was used during the preparation of the negative electrode slurry.

Comparative Example 2-1: Preparation of negative electrode slurry

A negative electrode slurry of Comparative Example 2-1 was prepared in the same manner as in Example 2-1, except that the negative electrode active material of Comparative Example 1-1 was used during the preparation of the negative electrode slurry.

Comparative Example 2-2: Preparation of negative electrode slurry

A negative electrode slurry of Comparative Example 2-2 was prepared in the same manner as in Example 2-1, except that the negative electrode active material of Comparative Example 1-2 was used during the preparation of the negative electrode slurry.

Comparative Example 2-3: Preparation of negative electrode slurry

A negative electrode slurry of Comparative Example 2-3 was prepared in the same manner as in Example 2-1, except that the negative electrode active material of Comparative Example 1-3 was used during the preparation of the negative electrode slurry.

Reference Example 2-1: Preparation of negative electrode slurry

A negative electrode slurry of Reference Example 2-1 was prepared in the same manner as in Example 2-1, except that no tannic acid additive was used during the preparation of the negative electrode slurry.

Reference Example 2-2: Preparation of negative electrode slurry

A negative electrode slurry of Reference Example 2-2 was prepared in the same manner as in Example 2-1, except that the tannic acid additive was used in an amount of 5 parts by weight during the preparation of the negative electrode slurry.

**<Evaluation of negative electrode slurry viscosity and gas generation amount>**

After the prepared negative electrode slurry was stored at room temperature for 2 days, a viscosity was measured at a temperature of 23°C using a rheometer (manufactured by TA Instruments, HR 20). Specifically, the relative viscosity (%) of the negative electrode slurry after storage at room temperature for 2 days is shown in Table 2 below, based on the viscosity immediately after the preparation of the negative electrode slurry.

Relative viscosity (%) = {Viscosity of negative electrode slurry after 2 days of storage /Viscosity immediately after preparation of negative electrode slurry} x 100%

Gas generation may be confirmed by putting 20 g of the aforementioned negative electrode slurry into a pouch, sealing the pouch, then storing the pouch in a chamber at 40°C for 7 days, and then measuring the changed volume of the pouch. In this case, the amount of gas generated may be confirmed by putting the sealed pouch into water and measuring the changed volume of water. The amount of gas generated is shown in Table 2 below.

[Table 2]

|  | Relative Viscosity (%) | Amount (mL) of gas generated after storage at 40°C for 7 days |
|---|---|---|
| Example 2-1 | 96 | 8 |
| Example 2-2 | 94 | 4 |
| Example 2-3 | 94 | 4 |
| Comparative Example 2-1 | 62 | 48 |
| Comparative Example 2-2 | 95 | 6 |
| Comparative Example 2-3 | 78 | 33 |
| Reference Example 2-1 | 94 | 8 |
| Reference Example 2-2 | 94 | 8 |

<Manufacture of negative electrode and lithium secondary battery>

Example 3-1: Manufacture of negative electrode and lithium secondary battery

The negative electrode slurry prepared in Example 2-1 was coated onto one surface of a copper current collector and dried. In this case, the temperature of the circulating air was 60°C. Then, the copper current collector was roll-pressed and punched to a predetermined size to prepare a negative electrode.

Li metal was used as a counter electrode, and after a polyolefin separator was interposed between the negative electrode and Li metal, an electrolyte in which 1 M $LiPF_6$ was dissolved into a solvent in which ethylene carbonate (EC) and diethyl carbonate (DEC) were mixed at a volume ratio of 30:70 was injected, thereby manufacturing a negative electrode and a lithium secondary battery in Example 3-1.

Example 3-2: Manufacture of negative electrode and lithium secondary battery

A negative electrode and a lithium secondary battery in Example 3-2 were manufactured in the same manner as in Example 3-1, except that the negative electrode slurry of Example 2-2 was used.

Example 3-3: Manufacture of negative electrode and lithium secondary battery

A negative electrode and a lithium secondary battery in Example 3-3 were manufactured in the same manner as in Example 3-1, except that the negative electrode slurry of Example 2-3 was used.

Comparative Example 3-1: Manufacture of negative electrode and lithium secondary battery

A negative electrode and a lithium secondary battery in Comparative Example 3-1 were manufactured in the same manner as in Example 3-1, except that the negative electrode slurry of Comparative Example 2-1 was used.

Comparative Example 3-2: Manufacture of negative electrode and lithium secondary battery

A negative electrode and a lithium secondary battery in Comparative Example 3-2 were manufactured in the same manner as in Example 3-1, except that the negative electrode slurry of Comparative Example 2-2 was used.

Comparative Example 3-3: Manufacture of negative electrode and lithium secondary battery

A negative electrode and a lithium secondary battery in Comparative Example 3-3 were manufactured in the same manner as in Example 3-1, except that the negative electrode slurry of Comparative Example 2-3 was used.

Reference Example 3-1: Manufacture of negative electrode and lithium secondary battery

A negative electrode and a lithium secondary battery in Reference Example 3-1 were manufactured in the same manner as in Example 3-1, except that the negative electrode slurry of Reference Example 2-1 was used.

Reference Example 3-2: Manufacture of negative electrode and lithium secondary battery

A negative electrode and a lithium secondary battery in Reference Example 3-2 were manufactured in the same manner as in Example 3-1, except that the negative electrode slurry of Reference Example 2-2 was used.

< Evaluation of discharge capacity, initial efficiency and cycle characteristics of secondary battery >

The discharge capacity, initial efficiency, and cycle characteristics were evaluated by charging and discharging the secondary batteries of Examples 3-1 to 3-3, Comparative Examples 3-1 to 3-3, and Reference Examples 3-1 and 3-2, and the results are shown in the following Table 3.

The batteries manufactured in Examples 3-1 to 3-3, Comparative Examples 3-1 to 3-3, and Reference Examples 3-1 and 3-2 were charged at a constant current (CC) of 0.1 C at 25°C until the voltage became 5 mV and then charged at a constant voltage (CV) until the charging current became 0.005 C (cut-off current), so as to perform the first charging. Thereafter, the batteries were left to stand for 20 minutes, and then discharged at a constant current (CC) of 0.1 C until the voltage became 1.5 V to confirm the initial efficiency.

Thereafter, the cycle characteristics were evaluated by repeating charging and discharging at 0.5 C up to 40 cycles to measure the capacity retention rate.

The initial efficiency (%) was derived from the results during first time charge/discharge by the following equation.

Initial efficiency (%) = {discharge capacity (mAh/g) of negative electrode active material / charge capacity (mAh/g) of negative electrode active material}×100%

The capacity retention rate was derived by the following calculation equation.

Capacity retention rate (%) = (40th time discharge capacity / first time discharge capacity)×100%

[Table 3]

|  | Discharge capacity (mAh/g) | Initial efficiency (%) | Capacity retention rate (%) |
|---|---|---|---|
| Example 3-1 | 1953 | 89 | 93 |
| Example 3-2 | 1901 | 87 | 90 |
| Example 3-3 | 1922 | 87 | 91 |
| Comparative Example 3-1 | 1934 | 88 | 84 |
| Comparative Example 3-2 | 1740 | 81 | 76 |
| Comparative Example 3-3 | 1938 | 88 | 88 |
| Reference Example 3-1 | 1910 | 87 | 87 |
| Reference Example 3-2 | 1895 | 85 | 80 |

From the results of Tables 2 and 3, it could be confirmed that in the case of Comparative Example 3-1, as a negative electrode slurry (Comparative Example 2-1) was prepared using a negative electrode active material (Comparative Example 1-1) in which a catechol derivative or gallol derivative coating layer was not formed, the gas generation suppression effect caused by the coating layer film was small, and the capacity retention rate was lower than those of Examples 3-1 to 3-3.

It could be confirmed that in the case of Comparative Example 3-2, the amount of gas generation was small due to the use of a negative electrode active material (Comparative Example 1-2) in which the coating layer was very thick by introducing the coating layer of a catechol derivative or gallol derivative in a content of 5 parts by weight or more based on total 100 parts by weight of the negative electrode active material, but the discharge capacity, initial efficiency, and capacity retention rate were reduced compared to Examples 3-1 to 3-3 because the coating layer was not a material that contributes to the initial efficiency and capacity retention rate.

It could be confirmed that in the case of Comparative Example 3-3, as a negative electrode slurry (Comparative Example 2-3) was prepared using a negative electrode active material (Comparative Example 1-3) in which a carbon layer was formed on a coating layer of a catechol derivative or gallol derivative, the gas generation suppression effect caused by the coating layer film was small because the coating layer of the catechol derivative or the gallol derivative was unable to properly prevent contact with water, and accordingly, processability deteriorated and the capacity retention rate was slightly reduced compared to Examples 3-1 to 3-3.

**Claims**

1. A negative electrode active material comprising:

   a silicon carbon composite;
   a carbon layer provided on at least a portion of the silicon carbon composite; and
   a coating layer of a catechol derivative or gallol derivative provided on at least a portion of at least one of the silicon carbon composite and the carbon layer.

2. The negative electrode active material of claim 1, wherein the catechol derivative comprises one or more selected from dopamine, norepinephrine, and catechin, or a salt thereof or a polymer thereof, and the gallol derivative comprises one or more selected from tannic acid, gallocatechin, and gallocatechin gallate, or a salt thereof or a polymer thereof.

3. The negative electrode active material of claim 1, wherein a content of the coating layer of the catechol derivative or gallol derivative is 0.5 parts by weight or more and less than 5 parts by weight based on total 100 parts by weight of the negative electrode active material.

4. The negative electrode active material of claim 1, wherein a content of the carbon layer is 0.1 to 50 parts by weight based on total 100 parts by weight of the negative electrode active material.

5. The negative electrode active material of claim 1, wherein the negative electrode active material has an average particle diameter ($D_{50}$) of 0.1 $\mu$m to 30 $\mu$m.

6. A method for preparing a negative electrode active material, the method comprising:

   forming a carbon layer on at least a portion of a silicon carbon composite; and
   forming a coating layer of a catechol derivative or gallol derivative on at least a portion of at least one of the silicon carbon composite and the carbon layer.

7. A negative electrode slurry comprising:

   a negative electrode active material comprising a silicon carbon composite and a coating layer of a catechol derivative or gallol derivative provided on at least a portion of the silicon carbon composite; and
   a catechol derivative or gallol derivative additive.

8. The negative electrode slurry of claim 7, wherein a content of the coating layer of the catechol derivative or gallol derivative is 0.5 parts by weight or more and less than 5 parts by weight based on total 100 parts by weight of the negative electrode active material.

9. The negative electrode slurry of claim 7, wherein a content of the catechol derivative or gallol derivative additive is 0.01 to 0.5 parts by weight based on total 100 parts by weight of the solid content of the negative electrode slurry.

10. The negative electrode slurry of claim 7, wherein the negative electrode active material comprises a carbon layer between the silicon carbon composite and the coating layer of a catechol derivative or a gallol derivative provided on at least a portion of the silicon carbon composite.

11. The negative electrode slurry of claim 10, wherein a content of the carbon layer is 0.1 to 50 parts by weight based on total 100 parts by weight of the negative electrode active material.

12. The negative electrode slurry of claim 7, further comprising a binder; and a conductive material.

13. A negative electrode comprising:

    a negative electrode current collector; and
    a negative electrode active material layer comprising the negative electrode slurry according to any one of claims 7 to 12 or a cured or polymerized product thereof provided on at least one surface of the negative electrode current collector.

14. A secondary battery comprising:

    the negative electrode of claim 13;
    a separator; and
    a positive electrode.

15. A battery module comprising the secondary battery of claim 14.

16. A battery pack comprising the secondary battery of claim 14.

17. A battery pack comprising the battery module of claim 15.

## INTERNATIONAL SEARCH REPORT

| International application No. |
| --- |
| **PCT/KR2024/016372** |

| A. | CLASSIFICATION OF SUBJECT MATTER |
| --- | --- |

**H01M 4/36**(2006.01)i; **H01M 4/587**(2010.01)i; **C01B 32/956**(2017.01)i; **H01M 4/134**(2010.01)i; **H01M 10/052**(2010.01)i; **H01M 4/02**(2006.01)i

According to International Patent Classification (IPC) or to both national classification and IPC

| B. | FIELDS SEARCHED |
| --- | --- |

Minimum documentation searched (classification system followed by classification symbols)

H01M 4/36(2006.01); C01B 32/15(2017.01); H01M 10/052(2010.01); H01M 4/13(2010.01); H01M 4/133(2010.01); H01M 4/38(2006.01); H01M 4/587(2010.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 음극 (anode), 실리콘-카본 복합체 (silicon-carbon complex), 탄소층 (carbon coating layer), 카테콜 유도체 (catechol derivative), 갈롤 유도체 (gallol derivative), 코어 (core), 쉘 (shell)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | KR 10-2023-0124422 A (SAMSUNG SDI CO., LTD. et al.) 25 August 2023 (2023-08-25) See abstract; paragraphs [0051], [0062], [0109] and [0114]-[0116]; and claims 1, 2, 6 and 8. | 7-9,12-17 |
| Y | | 1-6,10-11 |
| Y | KR 10-2014-0070416 A (LG CHEM, LTD.) 10 June 2014 (2014-06-10) See abstract; paragraph [0063]; and claims 1 and 4. | 1-6,10-11 |
| A | CN 106941164 A (SOUTHEAST UNIVERSITY) 11 July 2017 (2017-07-11) See abstract; and claims 1-6. | 1-17 |
| A | KR 10-2018-0007410 A (HANBAT NATIONAL UNIVERSITY INDUSTRY-ACADEMIC COOPERATION FOUNDATION) 23 January 2018 (2018-01-23) See abstract; and claims 1-10. | 1-17 |

✓ Further documents are listed in the continuation of Box C.　　✓ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **12 February 2025** | **12 February 2025** |

| Name and mailing address of the ISA/KR | Authorized officer |
| --- | --- |
| **Korean Intellectual Property Office Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT

| | International application No. |
|---|---|
| | **PCT/KR2024/016372** |

### C.    DOCUMENTS CONSIDERED TO BE RELEVANT

| Category* | Citation of document, with indication, where appropriate, of the relevant passages | Relevant to claim No. |
|---|---|---|
| A | KR 10-2019-0007245 A (SAMSUNG SDI CO., LTD.) 22 January 2019 (2019-01-22) See abstract; and claims 1-10. | 1-17 |

Form PCT/ISA/210 (second sheet) (July 2022)

**INTERNATIONAL SEARCH REPORT**
Information on patent family members

International application No.

**PCT/KR2024/016372**

| Patent document cited in search report | | | Publication date (day/month/year) | Patent family member(s) | | | Publication date (day/month/year) |
|---|---|---|---|---|---|---|---|
| KR | 10-2023-0124422 | A | 25 August 2023 | CN | 116632235 | A | 22 August 2023 |
| | | | | EP | 4231386 | A1 | 23 August 2023 |
| | | | | US | 2023-0268490 | A1 | 24 August 2023 |
| KR | 10-2014-0070416 | A | 10 June 2014 | CN | 104025348 | A | 03 September 2014 |
| | | | | EP | 2757619 | A1 | 23 July 2014 |
| | | | | EP | 2757619 | B1 | 17 August 2016 |
| | | | | JP | 2015-524149 | A | 20 August 2015 |
| | | | | JP | 6161015 | B2 | 12 July 2017 |
| | | | | US | 2014-0154564 | A1 | 05 June 2014 |
| | | | | US | 9711787 | B2 | 18 July 2017 |
| | | | | WO | 2014-084635 | A1 | 05 June 2014 |
| CN | 106941164 | A | 11 July 2017 | None | | | |
| KR | 10-2018-0007410 | A | 23 January 2018 | KR | 10-1876801 | B1 | 11 July 2018 |
| KR | 10-2019-0007245 | A | 22 January 2019 | CN | 111066180 | A | 24 April 2020 |
| | | | | CN | 111066180 | B | 15 July 2022 |
| | | | | KR | 10-2487626 | B1 | 12 January 2023 |
| | | | | US | 11515520 | B2 | 29 November 2022 |
| | | | | US | 2020-0152970 | A1 | 14 May 2020 |
| | | | | WO | 2019-013525 | A2 | 17 January 2019 |
| | | | | WO | 2019-013525 | A3 | 11 April 2019 |

Form PCT/ISA/210 (patent family annex) (July 2022)

**EP 4 664 553 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230147407

- KR 1020190129017